# EUROPEAN PATENT SPECIFICATION

(11) **EP 4 597 846 B1**
(45) Date of publication and mention of the grant of the patent: **09.12.2026**
(21) Application number: 25151221.6
(22) Date of filing: 10.01.2025
(51) Int. Cl.: H03L 7/087, H03L 7/10, H03L 7/093, H03J 3/20

(54) **LOW PHASE NOISE PHASE LOCKED LOOP**
PHASENREGELSCHLEIFE MIT NIEDRIGEM PHASENRAUSCHEN
BOUCLE À VERROUILLAGE DE PHASE À FAIBLE BRUIT DE PHASE

(43) Date of publication of application: 06.08.2025
(73) Proprietor: NXP B.V., 5656 AG Eindhoven (NL)
(72) Inventor: Verlinden, Jos, 5656AG Eindhoven (NL); Petricevic, Danilo, 5656AG Eindhoven (NL); Derksen, Sander, 5656AG Eindhoven (NL); Klumperink, Eric, 5656AG Eindhoven (NL)
(74) Representative: Schwarzweller, Thomas

(56) References cited:
- US-A1- 2014 218 124
- US-A1- 2015 015 313
- US-A1- 20240 072 813

## Description

### BACKGROUND

### Field

Embodiments of the present invention generally relates to alternating current signal generation, and more particularly relates to alternating current signal generators with low phase noise.

### Related Art

Many radio frequency (RF) systems incorporate signal generators that generate stable waveforms. Such stable waveforms are used, for example, as frequency references, signals that are able to be processed for RF transmission or to base receiver processing of received RF signals, other uses, or combinations of these. Many circuits are able to benefit from signal generators that have low phase noise characteristics. For example, US2024/072813A1, US2014/218124A1 and US2015/015313A1 disclose such signal generators.

### BRIEF DESCRIPTION OF THE DRAWINGS

Embodiments of the present invention is illustrated by way of example and is not limited by the accompanying figures, in which like references indicate similar elements. Elements in the figures are illustrated for simplicity and clarity and have not necessarily been drawn to scale.
FIG. 1 illustrates a Phase Locked Loop (PLL) circuit with wideband feedback, according to an example.
FIG. 2 illustrates an example tunable LC time reference circuit, according to an example.
FIG. 3 illustrates a first example PLL with wideband feedback, according to an example.
FIG. 4 illustrates a second example PLL with wideband feedback, according to an example.
FIG. 5 illustrates a process for generating a signal, according to an example.

### DETAILED DESCRIPTION

The below described systems and methods provide a Phase Locked Loop (PLL) oscillator with reduced phase noise characteristics. The below systems and methods allow realization of improved phase noise performance without incorporating costly process options or expensive discrete components. These systems and methods reduce phase noise characteristics by incorporating a wideband feedback loop around a PLL oscillator to reduce phase noise by including a series Inductor-Capacitor tank circuit (LC-tank) based time reference circuit into the wideband feedback loop. The LC-tank circuit based time reference circuit has a variable resonant frequency that is adjusted based on a detected phase or frequency error in the Phase Locked Loop circuit. The LC-tank circuit based time reference circuit introduces a particular time delay. At its resonant frequency, the output frequency of the phase locked loop is controlled to maintain that particular time delay.

Phase noise of a signal, such as of a frequency reference signal, in the context of the present discussion refers to frequency spectrum components that are near the desired frequency of the particular signal. Phase noise is well understood by practitioners of ordinary skill in the relevant arts and is generally considered to be an undesired component of a signal. In some examples, phase noise of a generated signal is affected by and can be reduced by the characteristics of feedback circuits controlling the operation of one or more oscillators generating that particular signal.

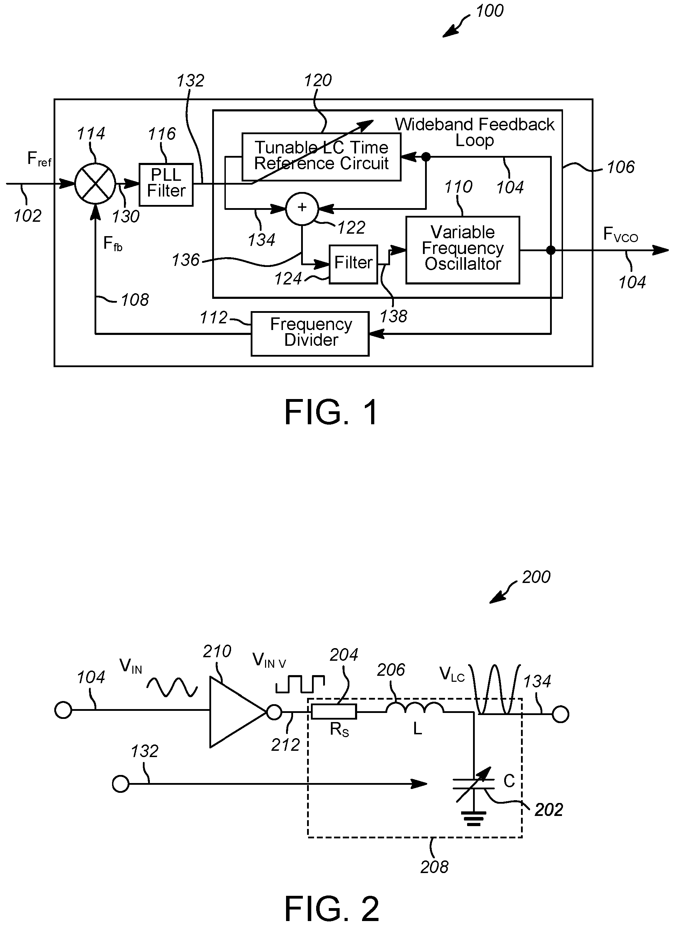

FIG. 1 illustrates a Phase Locked Loop (PLL) circuit with wideband feedback 100, according to an example. The illustrated PLL circuit with wideband feedback 100 depicts a high level block diagram of a PLL oscillator that incorporates a wideband feedback loop 106 with components to enhance its phase noise performance. The illustrated PLL circuit with wideband feedback 100 is an example of a signal generator. In various examples, various PLL architectures are able to be utilized in the implementation of a PLL circuit with wideband feedback 100. In various examples, PLL architectures including analog or digital circuits, integer or fractional frequency division of the feedback signal, designs incorporating techniques such as sub-sampling, injection locking, reference sampling, other techniques, or combinations of these are able to be incorporated in various implementations of a PLL circuit with wideband feedback 100.

The PLL circuit with wideband feedback 100 produces an output signal 104 that has a frequency set by the configuration of the components illustrated for the PLL circuit with wideband feedback 100. The frequency of the output signal 104 in the illustrated example is controlled by a reference frequency (F_{ref}) signal 102. The reference frequency signal 102 is able to be provided by a suitable reference as is familiar to persons of ordinary skill in the relevant arts.

The PLL circuit with wideband feedback 100 includes a variable frequency oscillator circuit 110 that produces the output signal 104 with a frequency that is controlled by a frequency control input signal 138. The variable frequency oscillator circuit 110 is an example of a controlled oscillator circuit and operates to vary the frequency of the output signal 104 based on an input received as a frequency control input signal 138. Processing performed by the components of the PLL circuit with wideband feedback 100 to produce the frequency control input signal 138 is described in further detail below. In various examples, the variable frequency oscillator circuit 110 is able to be implemented as a parallel LC-tank circuit based Voltage Controlled Oscillator (VCO), voltage controlled ring oscillator, current controlled ring oscillator, other designs, or combinations of these.

The output signal 104 produced by the variable frequency oscillator circuit 110 of the PLL circuit with wideband feedback 100 is provided to two feedback loops. The output signal 104 is provided to a frequency divider circuit 112 and to a tunable LC time reference circuit 120. The operation of these two feedback loops is described below.

The frequency divider circuit 112 produces a divided frequency output signal 108 by dividing the frequency of the output signal 104 by a value to produce the divided frequency output signal 108. In the illustrated example, the frequency divider circuit 112 is configured to divide the frequency of the output signal 104 by a value so as to be the same frequency as the frequency of the reference frequency signal 102 to allow comparison of the divided frequency output signal 108 to the reference frequency signal 102 to properly control the frequency of the output signal 104 as is described below. The frequency divider circuit 112 in various examples is configured to divide the frequency of the output signal 104 by a value that is able to include an integer value, a fractional value, in the case of a fractional-N frequency divider circuit, that is able to be a non-integer value less than or greater than one (1), or any number of combinations of these.

The reference frequency signal 102 and the divided frequency output signal 108 are provided to a phase frequency detector circuit 114. The phase frequency detector circuit 114 produces an error signal 130 that indicates a phase or frequency error between the reference frequency signal 102 and the divided frequency output signal 108. In an example, the error signal 130 is able have a magnitude of, for example, a voltage, current, digital data, other indicator, or combinations of these, to indicate the phase or frequency difference between the reference frequency signal 102 and the divided frequency output signal 108.

The error signal 130 is filtered by a Phase Locked Loop (PLL) filter circuit 116 to produce a filtered error signal 132. In general, the PLL filter circuit 116 is a low pass filter to condition the divided frequency output signal 108 to produce a filtered error signal 132 with time response characteristics suitable to properly control the frequency of the output signal 104 according to various design criteria.

A tunable LC time reference circuit 120 operates to produce a time reference signal 134. The tunable LC time reference circuit 120 receives the output signal 104. The output signal 104 drives a series LC-tank circuit within the tunable LC time reference circuit 120 to produce a time reference signal 134. The operation of the tunable LC time reference circuit 120 delays the time reference signal 134 based on a combination of a frequency of the output signal 104 and values of a series connected inductor and capacitor in the series LC-tank circuit. In an example, a value of one or more components in the series LC-tank circuit within the tunable LC time reference circuit 120, and thus the resonant frequency of the series LC-tank circuit, is varied based on the low pass filtered error signal 132. Examples of a tunable LC time reference circuit 120 is described below. In an example, the series LC-tank circuit within the tunable LC time reference circuit 120 introduces a defined time delay, which in an example is a ninety degree (90°) phase shift of the output signal 104 at the resonant frequency series LC-tank circuit, and introduces other phase shifts at frequencies different from the resonant frequency of the series LC-tank circuit.

The time reference signal 134 and the output signal 104 are provided to a time error detector circuit 122. The time error detector circuit 122 determines a time error signal 136 between the time reference signal 134 and the output signal 104. In an example, this time error signal is proportional to phase differences between the output signal 104 that is shifted by a ninety degree (90°) and the time reference signal 134. This operation causes the time error signal to be minimized when the frequency of the output signal 104 is equal to the resonant frequency of the series LC-tank circuit within the tunable LC time reference circuit 120, i.e., when the frequency shift introduced by the LC-tank circuit is ninety degree (90°).

The time error signal 136 is filtered by an oscillator filter 124 to produce the frequency control input signal 138 that controls the frequency of the output signal 104 produced by the variable frequency oscillator circuit 110.

FIG. 2 illustrates an example tunable LC time reference circuit 200, according to an example. The example tunable LC time reference circuit 200 depicts an example circuit to implement the above described tunable LC time reference circuit 120. The example tunable LC time reference circuit 200 forms a series LC-tank circuit that is driven by the above described output signal 104 and produces the time reference signal 134 that is delayed based on the frequency of the output signal 104. In further examples, the LC-tank circuit is driven by a signal derived from the output signal 104, such as a signal with a frequency equal to the frequency of the output signal 104 divided by a value that is a constant in an example.

The illustrated example tunable LC time reference circuit 200 includes an inductor 206, a series resistor 204 that represents the parasitic resistance of the inductor 206, and variable capacitor 202 that are arranged in a series circuit 208. The series circuit 208 includes a series connected indictor and capacitor. This components in the series circuit 208 are selected so as to have a desired resonant frequency that corresponds to a desired frequency of time reference signal 134.

The series circuit 208 is driven by an inverting amplifier circuit 210. The inverting amplifier circuit 210 in the illustrated example is a hard limiting amplifier that produces a square wave at its amplifier output 212. In general, the configuration of the series circuit 208 and the inverting amplifier circuit 210 produces an essentially square wave voltage (V_{IN V}) across the series circuit 208 and the operation of the series circuit 208 results in a sinusoidal electrical current flowing through the series circuit 208 and thus producing a sinusoidal voltage (V_{LC}) across the capacitor 202. The voltage across capacitor 202 is the output of the tunable LC time reference circuit 200 and is produced as the time reference signal 134. In further examples, the LC-tank circuit is driven by a signal derived from the output signal 104, such as a signal with a frequency equal to the frequency of the output signal 104 divided by a value that is able to be a constant. It is clear that the frequency of the output signal 104, or other signal driving the LC-tank circuit, is a basis for the frequency of the time reference signal 134.

The illustrated example tunable LC time reference circuit 200 has a variable capacitor 202 that has a capacitance value controlled by the above described filtered error signal 132. In an example, the variable capacitor is able to be a variable reactor, known as a varactor, that has a capacitance value based on the voltage across its terminals. In such an example, circuitry (not shown) produces a voltage across the variable capacitor 202 that is proportional to the filtered error signal 132. The filtered error signal 132 controls the value of the variable capacitor 202 and thus varies the frequency of the time reference signal 134. The filtered error signal 132 is thus part of a basis for the frequency of the time reference signal 134.

The illustrated example tunable LC time reference circuit 200 uses a series arrangement of indictive (L) components, such as inductor 206, and capacitive (C) components, such as variable capacitor 202, to form a series LC-tank circuit. It has been found that incorporation of a tunable LC time reference circuit that uses such a series LC connection into the PLL with wideband feedback 100 described above provides improved phase noise performance relative to using a tunable LC time reference circuit 120 that connects indictive components and capacitive components in a parallel configuration.

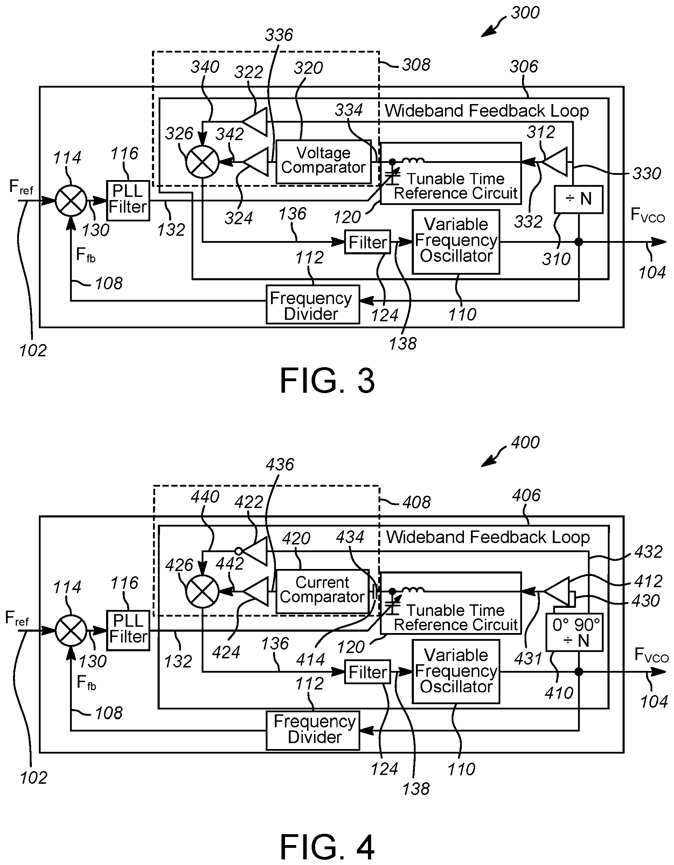

FIG. 3 illustrates a first example PLL with wideband feedback 300, according to an example. The first example PLL with wideband feedback 300 illustrates an example of a circuit to realize a version of the above described PLL circuit with wideband feedback 100. The first example PLL with wideband feedback 300 includes a first example wideband feedback loop 306 that has a first example time error detector circuit 308.

The first example PLL with wideband feedback 300 includes the above described elements of the first example PLL circuit with wideband feedback 100. In particular, elements including the above described variable frequency oscillator circuit 110, frequency divider circuit 112, phase frequency detector circuit 114, and PLL filter circuit 116 operate as described above and produce their respective signals as is also described above. The first example PLL with wideband feedback 300 includes a first example wideband feedback loop 306 that is an example of an implementation of the above described wideband feedback loop 106 with a first example time error detector circuit 308. The elements of the first example wideband feedback loop 306 and their operation is described below. As described below, the first example wideband feedback loop 306 includes components to support the operation of the first example time error detector circuit 308.

The first example wideband feedback loop 306 includes a divide-by-N (÷ N) circuit 310 that receives the output signal 104 and operates to divide the frequency of the output signal 104 by a number "N." The frequency of the output signal 104 in an example is divided by the divide-by-N circuit 310 in order to allow elements of the first example wideband feedback loop 306, such as the tunable LC time reference circuit 120, to be designed to operate and thus be optimized for frequencies that differ from the frequency of the output signal 104. In various examples, N is able to be an integer or a fractional number by which the frequency of the output signal 104 is divided. The divide-by-N circuit 310 produces a feedback signal 330 that consists of a signal with a frequency equal to the frequency of the output signal 104 divided by "N."

The feedback signal 330 is amplified by a feedback amplifier circuit 312 to condition the feedback signal 330 and produce a first amplified feedback signal 332 as an input into the tunable LC time reference circuit 120. An example of a tunable LC time reference circuit 120 is described above with regards to the example tunable LC time reference circuit 200.

The tunable LC time reference circuit 120 produces a first time reference signal 334. The tunable LC time reference circuit 120 introduces a time delay between the first amplified feedback signal 332 and the first time reference signal 334 that is based on the frequency of the amplified feedback signal in relationship to the resonant frequency of the LC-tank circuit within the tunable LC time reference circuit 120. In the illustrated example, the tunable LC time reference circuit 120 produces a first time reference signal 334 that has a ninety degree (90°) phase shift from its input, i.e., the first amplified feedback signal 332, when the frequency of the first amplified feedback signal 332 is at the resonant frequency of the LC-tank circuit.

The first time reference signal 334 is provided to a voltage comparator circuit 320 that, in some examples, produces a square wave first time reference signal 336 with the frequency of the first time reference signal 334. The square wave first time reference signal 336 is an example of a conditioned time reference signal and is amplified by a time reference amplifier circuit 324 to produce an amplified time reference signal 342. In this description, a square wave refers to any signal where transitions across a value, such as zero, are used to convey information and such square wave signals in some examples are able to have slew rates that are within specified minimum slew rate values, maximum slew rate values, or both minimum and maximum slew rate values. In an example, the time reference amplifier circuit 324 is a hard limiting amplifier that produces a two level signal. The amplified time reference signal 342 is provided to a first input of a time comparator circuit 326.

Returning to the feedback signal 330, the feedback signal 330 is amplified by a second feedback signal amplifier circuit 322 to produce a second amplified feedback signal 340. In an example, the second feedback signal amplifier circuit 322 is a hard limiting amplifier that produces a two level signal. The second amplified feedback signal 340 is provided as a second input to the time comparator circuit 326.

The time comparator circuit 326 compares two inputs, i.e., the amplified time reference signal 342 and the second amplified feedback signal 340, to produce a time error signal 136. The time comparison performed by the time comparator circuit 326 is equivalent to phase difference detection for a given signal frequency such as the frequency of the second amplified feedback signal 340 and amplified time reference signal 342. The time error signal 136 indicates a time difference between the second amplified feedback signal 340 and the amplified time reference signal 342 as introduced by the tunable LC time reference circuit 120. In an example, the time comparator circuit 326 produces an output proportional to the phase difference between one of its inputs and the other of its input shifted by ninety degrees (90°). In an example, the amplified time reference signal 342 and the second amplified feedback signal 340 are both square wave signals and the time comparator circuit 326 is implemented as a mixer. In further examples, the time comparator circuit 326 is able to be an exclusive-OR gate, other form of analog multiplier, other circuit, or combinations of these. The time error signal 136 is provided to the oscillator filter 124 to control the frequency of the variable frequency oscillator circuit 110 as is described above with regards to the above described PLL circuit with wideband feedback 100.

FIG. 4 illustrates a second example PLL with wideband feedback 400, according to an example. The second example PLL with wideband feedback 400 illustrates an example of a circuit to realize a version of the above described PLL circuit with wideband feedback 100. The second example PLL with wideband feedback 400 includes a second example wideband feedback loop 406 that has a second example time error detector circuit 408.

The second example PLL with wideband feedback 400 includes the above described elements of the first example PLL circuit with wideband feedback 100. In particular, elements including the above described variable frequency oscillator circuit 110, frequency divider circuit 112, phase frequency detector circuit 114, and PLL filter circuit 116 operate as described above and produce their respective signals as is also described above. The second example PLL with wideband feedback 400 includes a second example wideband feedback loop 406 that is an example of an implementation of the above described wideband feedback loop 106 with a second example time error detector circuit 408. The elements of the second example wideband feedback loop 406 and their operation is described below. As described below, the second example wideband feedback loop 406 includes components to support the operation of the second example time error detector circuit 408.

The second example wideband feedback loop 406 includes a phase shifting divide-by-N (÷ N) circuit 410 that receives the output signal 104 and operates to divide the frequency of the output signal 104 by a number "N." The frequency of the output signal 104 in an example is divided by the phase shifting divide-by-N circuit 410 in order to allow elements of the second example wideband feedback loop 406, such as the tunable LC time reference circuit 120, to be designed to operate and thus be optimized for frequencies that differ from the frequency of the output signal 104. In various examples, N is able to be an integer or a fractional number by which the frequency of the output signal 104 is divided. When N is not an integer, the phase shifting divide-by-N circuit 410 is referred to as a fractional-N frequency divider circuit when it divides the frequency of the output signal 104 by that fractional, i.e., non-integer, number. The phase shifting divide-by-N circuit 410 produces an in-phase feedback signal 430 and a phase shifted feedback signal 432 that consists of signals with a frequency equal to the frequency of the output signal 104 divided by "N." The phase shifted feedback signal 432 replicates the in-phase feedback signal 430 but is shifted ninety degrees (90°). This ninety degree (90°) phase shift is introduced to match the ninety degree (90°) phase shift added by the time error capacitor 414.

The in-phase feedback signal 430 is amplified by an in-phase amplifier 412 to condition the in-phase feedback signal 430 into an amplified in-phase feedback signal 431 to be used as an input into the tunable LC time reference circuit 120. An example of a tunable LC time reference circuit 120 is described above with regards to the example tunable LC time reference circuit 200.

The tunable LC time reference circuit 120 produces a second time reference signal 434. The tunable LC time reference circuit 120 introduces a time delay between the amplified in-phase feedback signal 431 and the second time reference signal 434 that is based on the frequency of the amplified in-phase feedback signal 431 in relationship to the resonant frequency of the LC-tank circuit within the tunable LC time reference circuit 120. In the illustrated example, the tunable LC time reference circuit 120 produces a second time reference signal 434 that has a ninety degree (90°) phase shift from its input, i.e., the amplified in-phase feedback signal 431, when the frequency of the amplified in-phase feedback signal 431 is at the resonant frequency of the LC-tank circuit.

The second time reference signal 434 is provided to a time error capacitor 414 in series with a current comparator circuit 420. The time error capacitor 414 and current comparator circuit 420 introduces another ninety degree (90°) phase shift in addition to the ninety degree (90°) phase shift introduced by the tunable LC time reference circuit 120 and produces a buffered second time reference signal 436 with the frequency of the second time reference signal 434 that is offset by one hundred and eighty degrees (180°) from the amplified in-phase feedback signal 431. The current comparator circuit 420, in some examples, produces a square wave as the buffered second time reference signal 436.

The buffered second time reference signal 436 is amplified by a time reference amplifier circuit 424 to produce an amplified time reference signal 442. In an example, the time reference amplifier circuit 424 is a hard limiting amplifier that produces a two level signal. The amplified time reference signal 442 is provided to a first input of a time comparator circuit 426.

Returning to the phase shifted feedback signal 432, the phase shifted feedback signal 432 is amplified by an inverting feedback signal amplifier circuit 422 to produce an inverted feedback signal 440. In an example, the inverting feedback signal amplifier circuit 422 is an example of an inverter circuit that operates as a hard limiting amplifier to produce an inverted feedback signal 440 that is a two level signal that is thus offset by one hundred and eighty degrees (180°) from the in-phase feedback signal 430. This one hundred and eighty degree (180°) phase shift matches the phase shift of the amplified time reference signal 442 relative to the in-phase feedback signal 430. The inverted feedback signal 440 is provided as a second input to the time comparator circuit 426.

The time comparator circuit 426 compares two inputs, i.e., the amplified time reference signal 442 and the inverted feedback signal 440, to produce a time error signal 136. The time comparison performed by the time comparator circuit 426 is equivalent to phase difference detection for a given signal frequency such as the frequency of the inverted feedback signal 440 and amplified time reference signal 442. The time error signal 136 indicates a time difference between the inverted feedback signal 440 and the amplified time reference signal 442 as introduced in part by the tunable LC time reference circuit 120. In an example, the amplified time reference signal 442 and the inverted feedback signal 440 are both square wave signals and the time comparator circuit 426 is implemented as a mixer. In further examples, the time comparator circuit 426 is able to be an exclusive-OR gate, other form of analog multiplier, other circuit, or combinations of these. The time error signal 136 is provided to the oscillator filter 124 to control the frequency of the variable frequency oscillator circuit 110 as is described above with regards to the above described PLL circuit with wideband feedback 100.

The above described first example PLL with wideband feedback 300 and second example PLL with wideband feedback 400 are two (2) variations of a PLL circuit with wideband feedback 100. Further variations of the above described PLL circuit with wideband feedback 100 are able to be realized based on variations of the first example PLL with wideband feedback 300 and second example PLL with wideband feedback 400. For example, alternative designs are able to combine the time comparator circuit 326 or time comparator circuit 426 and oscillator filter 124 into a single circuit structure. In some examples, the tunable LC time reference circuit 120, the first example wideband feedback loop 306, the second example wideband feedback loop 406, or combinations of these, are able to be realized as either a differential structure or a single-ended circuit structure. The oscillator filter 124 in various examples is able to be realized by any suitable structure such as active or passive circuits, proportional control operations, integrating control operations, or any combinations of these.

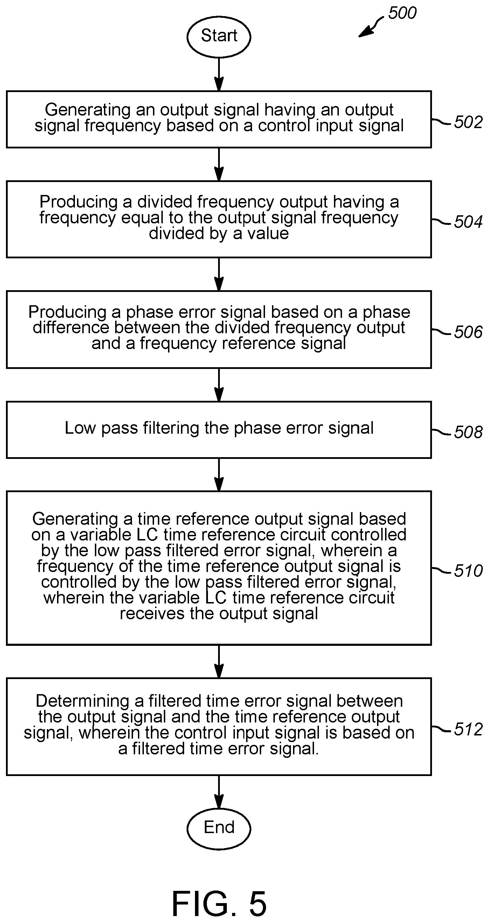

FIG. 5 illustrates a process for generating a signal 500, according to an example. The process for generating a signal 500 is a process performed by any of the PLL circuit with wideband feedback 100, the first example PLL with wideband feedback 300, or the second example PLL with wideband feedback 400, as are described above.

The process for generating a signal 500 generates, at 502, an output signal having an output signal frequency based on a control input signal. The output signal in an example is generated by the variable frequency oscillator circuit 110 described above.

A divided frequency output having a frequency equal to the output signal frequency divided by a value is generated, at 504. The divided frequency output in an example is generated by the frequency divider circuit 112 described above. In some examples, The value by which the output signal frequency is divided is able to be a constant.

A phase error signal is produced, at 506, based on a phase difference between the divided frequency output and a frequency reference signal. The phase error signal in an example is produced by the phase frequency detector circuit 114 described above.

The phase error signal is low pass filtered, at 508. Low pass filtering of the phase error signal in an example is performed by the PLL filter circuit 116 described above.

A time reference signal is generated, at 510, based on a tunable LC time reference circuit controlled by the low pass filtered error signal. The frequency of the time reference signal is controlled by the low pass filtered error signal and the tunable LC time reference circuit receives the output signal.

A filtered time error signal indicating time differences between the output signal and the time reference signal is determined, at 512. The control input signal, discussed above with regards to generating, at 502, an output signal having an output signal frequency based on a control input signal, is based on this filtered time error signal. The process for generating a signal 500 then ends.

In an example, a signal generator 100 includes a controlled oscillator circuit 110 configured to generate an output signal 104 having an output signal frequency based on a control input signal 138. The signal generator also includes a frequency divider circuit 112 configured to produce a divided frequency output 108 having a frequency equal to the output signal frequency divided by a value. The signal generator also includes a phase frequency detector circuit 114 configured to produce a phase error signal 130 based on a phase difference between the divided frequency output and a frequency reference signal 102. The signal generator further has a Phase Locked Loop (PLL) filter circuit 116 configured to generate a low pass filtered error signal 132 with a frequency based on low pass filtering the phase error signal. The signal generator has a tunable LC time reference circuit 120 comprising an LC-tank circuit 208 having a resonant frequency based on the low pass filtered error signal, the tunable LC time reference circuit configured to receive the output signal, generate a time reference signal 134, and introduce a determined time delay relative to the output signal when the output signal frequency is at the resonant frequency. The signal generator also includes a time error detector circuit 122 configured to determine a filtered time error signal 136 indicating a time error between the output signal and the time reference signal, wherein the control input signal is based on a filtered time error signal 138.

In another example, a method of generating a signal 500 includes generating 502 an output signal 104 having an output signal frequency based on a control input signal 138, producing 504 a divided frequency output 108 having a frequency equal to the output signal frequency divided by a value, producing 506 a phase error signal 130 based on a phase difference between the divided frequency output and a frequency reference signal 102, low pass filtering 508 the phase error signal to produce a filtered error signal 132. The method also includes generating 510, based on the output signal, a time reference signal 134, wherein the time reference signal is generated by a tunable LC time reference circuit 208 having a resonant frequency based on the low pass filtered error signal, and wherein the time reference signal has a determined time delay relative to the output signal when the output signal frequency is at the resonant frequency. The method also includes determining 512 a filtered time error signal 138 indicating a time error between the output signal and the time reference signal, wherein the control input signal is based on a filtered time error signal.

The term "coupled", as used herein, is defined as "connected" and encompasses the coupling of devices that may be physically, electrically or communicatively connected, although the coupling may not necessarily be directly and not necessarily be mechanical. The term "configured to" describes hardware, software, or a combination of hardware and software that is adapted to, set up, arranged, built, composed, constructed, designed, or that has any combination of these characteristics to carry out a given function. The term "adapted to" describes hardware, software, or a combination of hardware and software that is capable of, able to accommodate, to make, or that is suitable to carry out a given function.

The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to invention embodiments containing only one such element, even when the same claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The term "coupled", as used herein, is not intended to be limited to a direct coupling or a mechanical coupling, and that one or more additional elements may be interposed between two elements that are coupled.

As will be appreciated by one skilled in the art, aspects of the present disclosure may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "circuit" or "system".

The one or more embodiments of the invention may be a system, a method, and/or a computer program product. The computer program product may include a computer-readable storage medium (or media) having computer readable program instructions thereon for causing a processor to carry out aspects of the inventive embodiments.

In one embodiment, the computer program product includes a non-transitory storage medium readable by a processing circuit and storing instructions for execution by the processing circuit for performing a method. The computer-readable storage medium can be a tangible device that can retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media, e.g., light pulses passing through a fiber-optic cable), or electrical signals transmitted through a wire.

Computer-readable program instructions for carrying out operations of the inventive embodiments may be assembler instructions, instruction-set-architecture (ISA) instructions, machine instructions, machine-dependent instructions, microcode, firmware instructions, state-setting data, or either source code or object code written in any combination of one or more programming languages, including an object-oriented programming language such as Smalltalk, C++, and conventional procedural programming languages, such as the "C" programming language or similar programming languages. The computer-readable program instructions may execute entirely or partly on a user's computer or entirely or partly on a remote computer or server. In the latter scenario, the remote computer may be connected to the user's computer through any type of network, including a local area network (LAN), a wide area network (WAN), an Ultra-Wide Band (UWB) network, or the connection may be made to an external computer (for example, through the Internet). In some embodiments, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform aspects of the inventive embodiments.

Aspects of one or more embodiments of the invention are described herein with reference to flowchart illustrations and/or block diagrams of methods, apparatus (systems), and computer program products according to embodiments of the invention. Each block of the flowchart illustrations and/or block diagrams, and combinations of blocks in the flowchart illustrations and/or block diagrams, can be implemented by computer readable program instructions.

These computer-readable program instructions may be provided to a processor of a general-purpose computer, special purpose computer, or other programmable data processing apparatus to produce a machine, such that the instructions, which execute via the processor of the computer, create means for implementing the functions/acts specified in the flowchart and/or block diagram blocks. These computer-readable program instructions may also be stored in a computer-readable storage medium that can direct a computer to function in a particular manner, such that the computer-readable storage medium having instructions stored therein comprises an article of manufacture including instructions which implement aspects of the function/act specified in the flowchart and/or block diagram block or blocks.

The description of the present disclosure has been presented for purposes of illustration and description but is not intended to be exhaustive or limited to the inventive embodiments in the form disclosed. Many modifications and variations will be apparent to those of ordinary skill in the art without departing from the scope of the inventive embodiments. One or more embodiments were chosen and described in order to best explain the principles of the inventive subject matter and the practical application and to enable others of ordinary skill in the art to understand the inventive subject matter for various embodiments with various modifications as are suited to the particular use contemplated.

Although specific embodiments of the invention have been disclosed, those having ordinary skill in the art will understand that changes can be made to the specific embodiments without departing from the scope of the inventive embodiments. The scope of the invention is defined by the appended set of claims.

## Claims

1. A signal generator (100), comprising:
a controlled oscillator circuit (110) configured to generate an output signal (104) having an output signal frequency based on a control input signal;
a frequency divider circuit (112) configured to produce a divided frequency output (108) having a frequency equal to the output signal frequency divided by a value;
a phase frequency detector circuit (114) configured to produce a phase error signal (130) based on a phase difference between the divided frequency output and a frequency reference signal (102);
a Phase Locked loop, filter circuit (116) configured to generate a low pass filtered error signal (132) with a frequency based on low pass filtering the phase error signal;
wherein the signal generator is **characterized in that** it further comprises:
a tunable LC time reference circuit (120) comprising an LC-tank circuit (208) having a resonant frequency based on the low pass filtered error signal, the tunable LC time reference circuit configured to receive the output signal, and generate a time reference signal (134), wherein the time reference signal has a determined time delay relative to the output signal when the output signal frequency is at the resonant frequency; and
a time error detector circuit (122) configured to determine a filtered time error signal (138) indicating a time error between the output signal and the time reference signal,
wherein the control input signal is based on the filtered time error signal.

2. The signal generator of claim 1, further comprising:
a phase shifting divide-by-N circuit configured to receive the output signal and produce an in-phase feedback signal and a phase shifted feedback signal,
wherein the in-phase feedback signal and the phase shifted feedback signal have a frequency equal to the output signal frequency divided by a value, and
wherein the phase shifted feedback signal is shifted ninety degrees from the in-phase feedback signal,
wherein the time error detector circuit comprises:
a current comparator circuit configured to receive the time reference signal and produce a conditioned time reference signal; and
a time comparator circuit configured to determine a time error signal based on a time difference between the conditioned time reference signal and the phase shifted feedback signal, wherein the filtered time error signal is based on the time error signal.

3. The signal generator of claim 2, where the phase shifting divide-by-N circuit comprises a fractional-N frequency divider circuit.

4. The signal generator of claim 2, where the phase shifting divide-by-N circuit comprises an integer-N frequency divider circuit.

5. The signal generator of claim 1, further comprising:
a divide-by-N circuit configured to receive the output signal and produce a feedback signal, where the feedback signal has a frequency equal to the output signal frequency divided by a value, and
wherein the time error detector circuit comprises:
a voltage comparator circuit configured to receive the time reference signal and produce a conditioned time reference signal; and
a time comparator circuit configured to determine a time error signal based on a time difference between the conditioned time reference signal and the feedback signal, wherein the filtered time error signal is based on the time error signal.

6. The signal generator of claim 5, wherein the tunable LC time reference circuit induces a ninety degree phase shift between the output signal and the time reference signal, and wherein the time error detector circuit further comprises:
a time error capacitor configured to receive the time reference signal and couple the tunable LC time reference circuit to a current comparator circuit; and
an inverter circuit configured to invert the feedback signal and provide an inverted feedback signal to the time comparator circuit.

7. A method of generating a signal (500), comprising:
generating (502) an output signal having an output signal frequency based on a control input signal;
producing (504) a divided frequency output having a frequency equal to the output signal frequency divided by a value;
producing (506) a phase error signal based on a phase difference between the divided frequency output and a frequency reference signal;
low pass filtering (508) the phase error signal to produce a filtered error signal;
wherein the method is **characterized in that** it further comprises the steps of:
generating (510), based on the output signal, a time reference signal, wherein the time reference signal is generated by a tunable LC time reference circuit having a resonant frequency based on the low pass filtered error signal, and wherein the time reference signal has a determined time delay relative to the output signal when the output signal frequency is at the resonant frequency; and
determining (512) a filtered time error signal indicating a time error between the output signal and the time reference signal,
wherein the control input signal is based on a filtered time error signal.

8. The method of claim 7, further comprising:
producing an in-phase feedback signal and a phase shifted feedback signal based on the output signal,
wherein the in-phase feedback signal and the phase shifted feedback signal have a frequency equal to the output signal frequency divided by a value, and
wherein the phase shifted feedback signal is shifted ninety degrees from the in-phase feedback signal;
producing a conditioned time reference signal based on the time reference signal; and
determining a time error signal based on a time difference between the conditioned time reference signal and the phase shifted feedback signal, wherein the filtered time error signal is based on the time error signal.

9. The method of claim 8, wherein the value comprises a fractional value.

10. The method of claim 8, wherein the value comprises an integer value.

11. The method of claim 7, further comprising:
producing a feedback signal based on the output signal, where the feedback signal has a frequency equal to the output signal frequency divided by a value, and
producing a conditioned time reference signal based on the time reference signal; and
determining a time error signal based on a time difference between the conditioned time reference signal and the feedback signal, wherein the filtered time error signal is based on the time error signal.

## Patentansprüche

1. Signalgenerator (100), der Folgendes umfasst:
eine gesteuerte Oszillatorschaltung (110), die dazu ausgelegt ist, ein Ausgangssignal (104) mit einer Ausgangssignalfrequenz basierend auf einem Steuereingangssignal zu generieren;
eine Frequenzteilerschaltung (112), die dazu ausgelegt ist, eine Ausgabe mit geteilter Frequenz (108) zu erzeugen, die eine Frequenz aufweist, die gleich der Ausgangssignalfrequenz geteilt durch einen Wert ist;
eine Phasenfrequenzdetektorschaltung (114), die dazu ausgelegt ist, ein Phasenfehlersignal (130) basierend auf einer Phasendifferenz zwischen der Ausgabe mit geteilter Frequenz und einem Frequenzreferenzsignal (102) zu erzeugen;
eine Phasenregelschleifen(PLL)-Filterschaltung (116), die dazu ausgelegt ist, ein tiefpassgefiltertes Fehlersignal (132) mit einer Frequenz basierend auf einer Tiefpassfilterung des Phasenfehlersignals zu erzeugen;
wobei der Signalgenerator **dadurch gekennzeichnet ist, dass** er ferner Folgendes umfasst:
eine abstimmbare LC-Zeitreferenzschaltung (120), die einen LC-Schwingkreis (208) mit einer Resonanzfrequenz basierend auf dem tiefpassgefilterten Fehlersignal umfasst, wobei die abstimmbare LC-Zeitreferenzschaltung dazu ausgelegt ist, das Ausgangssignal zu empfangen und ein Zeitreferenzsignal (134) zu generieren,
wobei das Zeitreferenzsignal eine bestimmte Zeitverzögerung relativ zu dem Ausgangssignal aufweist, wenn die Ausgangssignalfrequenz bei der Resonanzfrequenz liegt; und
eine Zeitfehlerdetektorschaltung (122), die dazu ausgelegt ist, ein gefiltertes Zeitfehlersignal (138) zu bestimmen, das einen Zeitfehler zwischen dem Ausgangssignal und dem Zeitreferenzsignal angibt,
wobei das Steuereingangssignal auf dem gefilterten Zeitfehlersignal basiert.

2. Signalgenerator nach Anspruch 1, ferner umfassend:
eine phasenverschiebende Teilen-durch-N-Schaltung, die dazu ausgelegt ist, das Ausgangssignal zu empfangen und ein in-Phase-Rückkopplungssignal und ein phasenverschobenes Rückkopplungssignal zu erzeugen,
wobei das in-Phase-Rückkopplungssignal und das phasenverschobene Rückkopplungssignal eine Frequenz aufweisen, die gleich der Ausgangssignalfrequenz geteilt durch einen Wert ist, und
wobei das phasenverschobene Rückkopplungssignal neunzig Grad von dem in-Phase-Rückkopplungssignal verschoben ist,
wobei die Zeitfehlerdetektorschaltung Folgendes umfasst:
eine Stromkomparatorschaltung, die dazu ausgelegt ist, das Zeitreferenzsignal zu empfangen und ein konditioniertes Zeitreferenzsignal zu erzeugen; und
eine Zeitkomparatorschaltung, die dazu ausgelegt ist, ein Zeitfehlersignal basierend auf einer Zeitdifferenz zwischen dem konditionierten Zeitreferenzsignal und dem phasenverschobenen Rückkopplungssignal zu bestimmen, wobei das gefilterte Zeitfehlersignal auf dem Zeitfehlersignal basiert.

3. Signalgenerator nach Anspruch 2, wobei die phasenverschiebende Teilen-durch-N-Schaltung eine Bruch-N-Frequenzteilerschaltung umfasst.

4. Signalgenerator nach Anspruch 2, wobei die phasenverschiebende Teilen-durch-N-Schaltung eine Ganzzahl-N-Frequenzteilerschaltung umfasst.

5. Signalgenerator nach Anspruch 1, ferner umfassend:
eine Teilen-durch-N-Schaltung, die dazu ausgelegt ist, das Ausgangssignal zu empfangen und ein Rückkopplungssignal zu erzeugen, wobei das Rückkopplungssignal eine Frequenz aufweist, die gleich der Ausgangssignalfrequenz geteilt durch einen Wert ist, und
wobei die Zeitfehlerdetektorschaltung Folgendes umfasst:
eine Spannungskomparatorschaltung, die dazu ausgelegt ist, das Zeitreferenzsignal zu empfangen und ein konditioniertes Zeitreferenzsignal zu erzeugen; und
eine Zeitkomparatorschaltung, die dazu ausgelegt ist, ein Zeitfehlersignal basierend auf einer Zeitdifferenz zwischen dem konditionierten Zeitreferenzsignal und dem Rückkopplungssignal zu bestimmen, wobei das gefilterte Zeitfehlersignal auf dem Zeitfehlersignal basiert.

6. Signalgenerator nach Anspruch 5, wobei die abstimmbare LC-Zeitreferenzschaltung eine neunzig-Grad-Phasenverschiebung zwischen dem Ausgangssignal und dem Zeitreferenzsignal induziert und
wobei die Zeitfehlerdetektorschaltung ferner Folgendes umfasst:
einen Zeitfehlerkondensator, der dazu ausgelegt ist, das Zeitreferenzsignal zu empfangen und die abstimmbare LC-Zeitreferenzschaltung mit einer Stromkomparatorschaltung zu koppeln; und
eine Inverterschaltung, die dazu ausgelegt ist, das Rückkopplungssignal zu invertieren und der Zeitkomparatorschaltung ein invertiertes Rückkopplungssignal bereitzustellen.

7. Verfahren zum Generieren eines Signals (500), das Folgendes umfasst:
Generieren (502) eines Ausgangssignals mit einer Ausgangssignalfrequenz basierend auf einem Steuereingangssignal;
Erzeugen (504) einer Ausgabe mit geteilter Frequenz, die eine Frequenz aufweist, die gleich der Ausgangssignalfrequenz geteilt durch einen Wert ist;
Erzeugen (506) eines Phasenfehlersignals basierend auf einer Phasendifferenz zwischen der Ausgabe mit geteilter Frequenz und einem Frequenzreferenzsignal;
Tiefpassfiltern (508) des Phasenfehlersignals, um ein tiefpassgefiltertes Fehlersignal zu erzeugen;
wobei das Verfahren **dadurch gekennzeichnet ist, dass** es ferner die folgenden Schritte umfasst:
Generieren (510), basierend auf dem Ausgangssignal, eines Zeitreferenzsignals, wobei das Zeitreferenzsignal durch eine abstimmbare LC-Zeitreferenzschaltung mit einer Resonanzfrequenz basierend auf dem tiefpassgefilterten Fehlersignal generiert wird und wobei das Zeitreferenzsignal eine bestimmte Zeitverzögerung relativ zu dem Ausgangssignal aufweist, wenn die Ausgangssignalfrequenz bei der Resonanzfrequenz liegt; und
Bestimmen (512) eines gefilterten Zeitfehlersignals, das einen Zeitfehler zwischen dem Ausgangssignal und dem Zeitreferenzsignal angibt,
wobei das Steuereingangssignal auf einem gefilterten Zeitfehlersignal basiert.

8. Verfahren nach Anspruch 7, ferner umfassend:
Erzeugen eines in-Phase-Rückkopplungssignals und eines phasenverschobenen Rückkopplungssignals basierend auf dem Ausgangssignal,
wobei das in-Phase-Rückkopplungssignal und das phasenverschobene Rückkopplungssignal eine Frequenz aufweisen, die gleich der Ausgangssignalfrequenz geteilt durch einen Wert ist, und
wobei das phasenverschobene Rückkopplungssignal neunzig Grad von dem in-Phase-Rückkopplungssignal verschoben ist;
Erzeugen eines konditionierten Zeitreferenzsignals basierend auf dem Zeitreferenzsignal; und
Bestimmen eines Zeitfehlersignals basierend auf einer Zeitdifferenz zwischen dem konditionierten Zeitreferenzsignal und dem phasenverschobenen Rückkopplungssignal, wobei das gefilterte Zeitfehlersignal auf dem Zeitfehlersignal basiert.

9. Verfahren nach Anspruch 8, wobei der Wert einen Bruchwert umfasst.

10. Verfahren nach Anspruch 8, wobei der Wert einen ganzzahligen Wert umfasst.

11. Verfahren nach Anspruch 7, das ferner umfasst:
Erzeugen eines Rückkopplungssignals basierend auf dem Ausgangssignal, wobei das Rückkopplungssignal eine Frequenz aufweist, die gleich der Ausgangssignalfrequenz geteilt durch einen Wert ist, und
Erzeugen eines konditionierten Zeitreferenzsignals basierend auf dem Zeitreferenzsignal; und
Bestimmen eines Zeitfehlersignals basierend auf einer Zeitdifferenz zwischen dem konditionierten Zeitreferenzsignal und dem Rückkopplungssignal, wobei das gefilterte Zeitfehlersignal auf dem Zeitfehlersignal basiert.

## Revendications

1. Générateur de signal (100), comprenant :
un circuit oscillateur commandé (110) configuré pour générer un signal de sortie (104) ayant une fréquence de signal de sortie basée sur un signal d'entrée de commande ;
un circuit diviseur de fréquence (112) configuré pour produire une sortie à fréquence divisée (108) ayant une fréquence égale à la fréquence de signal de sortie divisée par une valeur ;
un circuit détecteur de phase et de fréquence (114) configuré pour produire un signal d'erreur de phase (130) sur la base d'une différence de phase entre la sortie à fréquence divisée et un signal de référence de fréquence (102) ;
un circuit de filtre de boucle à verrouillage de phase, PLL, (116) configuré pour générer un signal d'erreur filtré passe-bas (132) avec une fréquence basée sur un filtrage passe-bas du signal d'erreur de phase ;
le générateur de signal étant **caractérisé en ce qu'**il comprend en outre :
un circuit de référence temporelle LC accordable (120) comprenant un circuit bouchon LC (208) ayant une fréquence de résonance basée sur le signal d'erreur filtré passe-bas, le circuit de référence temporelle LC accordable étant configuré pour recevoir le signal de sortie et générer un signal de référence temporelle (134),
le signal de référence temporelle présentant un retard temporel déterminé par rapport au signal de sortie lorsque la fréquence de signal de sortie est à la fréquence de résonance ; et
un circuit détecteur d'erreur temporelle (122) configuré pour déterminer un signal d'erreur temporelle filtré (138) indiquant une erreur temporelle entre le signal de sortie et le signal de référence temporelle,
dans lequel le signal d'entrée de commande est basé sur le signal d'erreur temporelle filtré.

2. Générateur de signal selon la revendication 1, comprenant en outre :
un circuit de division par N à déphasage configuré pour recevoir le signal de sortie et produire un signal de rétroaction en phase et un signal de rétroaction déphasé,
le signal de rétroaction en phase et le signal de rétroaction déphasé ayant une fréquence égale à la fréquence de signal de sortie divisée par une valeur, et
le signal de rétroaction déphasé étant déphasé de quatre-vingt-dix degrés par rapport au signal de rétroaction en phase,
dans lequel le circuit détecteur d'erreur temporelle comprend :
un circuit de comparaison de courant configuré pour recevoir le signal de référence temporelle et produire un signal de référence temporelle conditionné ; et
un circuit de comparaison temporelle configuré pour déterminer un signal d'erreur temporelle sur la base d'une différence temporelle entre le signal de référence temporelle conditionné et le signal de rétroaction déphasé, le signal d'erreur temporelle filtré étant basé sur le signal d'erreur temporelle.

3. Générateur de signal selon la revendication 2, dans lequel le circuit de division par N à déphasage comprend un circuit diviseur de fréquence à rapport de division fractionnaire N.

4. Générateur de signal selon la revendication 2, dans lequel le circuit de division par N à déphasage comprend un circuit diviseur de fréquence à rapport de division entier N.

5. Générateur de signal selon la revendication 1, comprenant en outre :
un circuit de division par N configuré pour recevoir le signal de sortie et produire un signal de rétroaction, le signal de rétroaction ayant une fréquence égale à la fréquence de signal de sortie divisée par une valeur, et dans lequel le circuit détecteur d'erreur temporelle comprend :
un circuit de comparaison de tension configuré pour recevoir le signal de référence temporelle et produire un signal de référence temporelle conditionné ; et
un circuit de comparaison temporelle configuré pour déterminer un signal d'erreur temporelle sur la base d'une différence temporelle entre le signal de référence temporelle conditionné et le signal de rétroaction, le signal d'erreur temporelle filtré étant basé sur le signal d'erreur temporelle.

6. Générateur de signal selon la revendication 5, dans lequel le circuit de référence temporelle LC accordable induit un déphasage de quatre-vingt-dix degrés entre le signal de sortie et le signal de référence temporelle, et
dans lequel le circuit détecteur d'erreur temporelle comprend en outre :
un condensateur d'erreur temporelle configuré pour recevoir le signal de référence temporelle et coupler le circuit de référence temporelle LC accordable à un circuit de comparaison de courant ; et
un circuit inverseur configuré pour inverser le signal de rétroaction et fournir un signal de rétroaction inversé au circuit de comparaison temporelle.

7. Procédé de génération d'un signal (500), comprenant :
la génération (502) d'un signal de sortie ayant une fréquence de signal de sortie basée sur un signal d'entrée de commande ;
la production (504) d'une sortie à fréquence divisée ayant une fréquence égale à la fréquence de signal de sortie divisée par une valeur ;
la production (506) d'un signal d'erreur de phase sur la base d'une différence de phase entre la sortie à fréquence divisée et un signal de référence de fréquence ;
le filtrage passe-bas (508) du signal d'erreur de phase pour produire un signal d'erreur filtré passe-bas ;
le procédé étant **caractérisé en ce qu'**il comprend en outre les étapes suivantes :
la génération (510), sur la base du signal de sortie, d'un signal de référence temporelle, le signal de référence temporelle étant généré par un circuit de référence temporelle LC accordable ayant une fréquence de résonance basée sur le signal d'erreur filtré passe-bas, et le signal de référence temporelle ayant un retard temporel déterminé par rapport au signal de sortie lorsque la fréquence de signal de sortie est à la fréquence de résonance ; et
la détermination (512) d'un signal d'erreur temporelle filtré indiquant une erreur temporelle entre le signal de sortie et le signal de référence temporelle,
dans lequel le signal d'entrée de commande est basé sur le signal d'erreur temporelle filtré.

8. Procédé selon la revendication 7, comprenant en outre :
la production d'un signal de rétroaction en phase et d'un signal de rétroaction déphasé sur la base du signal de sortie,
le signal de rétroaction en phase et le signal de rétroaction déphasé ayant une fréquence égale à la fréquence de signal de sortie divisée par une valeur, et le signal de rétroaction déphasé étant déphasé de quatre-vingt-dix degrés par rapport au signal de rétroaction en phase ;
la production d'un signal de référence temporelle conditionné sur la base du signal de référence temporelle ; et
la détermination d'un signal d'erreur temporelle sur la base d'une différence temporelle entre le signal de référence temporelle conditionné et le signal de rétroaction déphasé, le signal d'erreur temporelle filtré étant basé sur le signal d'erreur temporelle.

9. Procédé selon la revendication 8, dans lequel la valeur comprend une valeur fractionnaire.

10. Procédé selon la revendication 8, dans lequel la valeur comprend une valeur entière.

11. Procédé selon la revendication 7, comprenant en outre :
la production d'un signal de rétroaction sur la base du signal de sortie, le signal de rétroaction ayant une fréquence égale à la fréquence de signal de sortie divisée par une valeur, et
la production d'un signal de référence temporelle conditionné sur la base du signal de référence temporelle ; et
la détermination d'un signal d'erreur temporelle sur la base d'une différence temporelle entre le signal de référence temporelle conditionné et le signal de rétroaction, le signal d'erreur temporelle filtré étant basé sur le signal d'erreur temporelle.
